# EUROPEAN PATENT APPLICATION

(11) **EP 4 531 078 A1**
(43) Date of publication of application: **02.04.2025**
(21) Application number: 23199726.3
(22) Date of filing: 26.09.2023
(51) Int. Cl.: H01L 21/56, H01L 23/495

(54) **METHOD OF AND INTERMEDIATE FOR MANUFACTURING A SEMICONDUCTOR DIE PACKAGE**

(71) Applicant: Nexperia B.V., 6534 AB Nijmegen (NL)
(72) Inventor: Leung, Chi Ho, Hong Kong (HK); Yeung, Shun Tik, Hong Kong (HK)
(74) Representative: Pjanovic, Ilija

(57) **Abstract**

There is provided a method of manufacturing a semiconductor die package. The method comprises providing a leadframe having a sub-structure and at least one tie bar, the sub-structure comprising a terminal-forming portion in electrical communication with the at least one tie bar. The method comprises bonding a die to the sub-structure. The method comprises encapsulating the sub-structure and the die within an encapsulation layer. The method comprises performing a first cut through the terminal-forming portion and the encapsulation layer so as to form a side terminal, whilst leaving all tie bars substantially intact. The method comprises electroplating the side terminal. The method comprises performing a second cut through the tie bar and the encapsulation layer to singulate a semiconductor die package from the leadframe.

## Description

The present invention relates to a method of manufacturing a semiconductor die package and a manufacturing intermediate for a semiconductor die package with improved electroplating capability.

Semiconductors are devices that are used within electronic circuitry. An individual semiconductor device is known as a die. So as to enable semiconductor dies to integrate within electronic circuitry, semiconductors dies are typically provided in a housing, known as a die package. Such die packages typically encapsulate the semiconductor die within a block of insulating material, such as plastic.

In order to permit electrical communication between the die and any electrical circuit within which it is to be incorporated, the die package comprises a number of terminals. In some configurations, the terminals extend outwards from the die package housing. Such configurations are known as 'leaded' die packages. In other configurations, the terminals are formed flush with the sides of the die package housing. Such configurations are known as 'leadless' die packages.

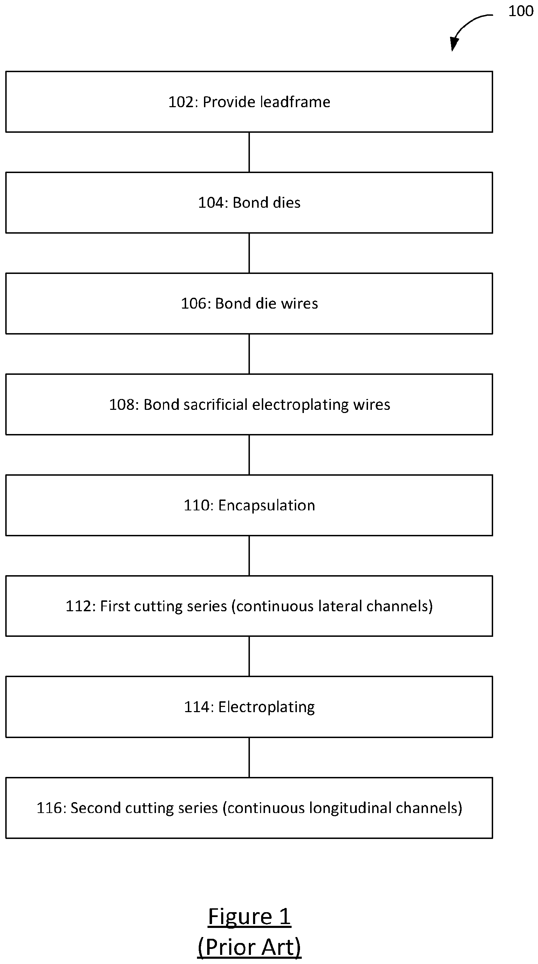

US 9,443,791 B2 describes a prior art method 100 of manufacturing a leadless die package, which is summarised below with references to Figures 1 to 4.

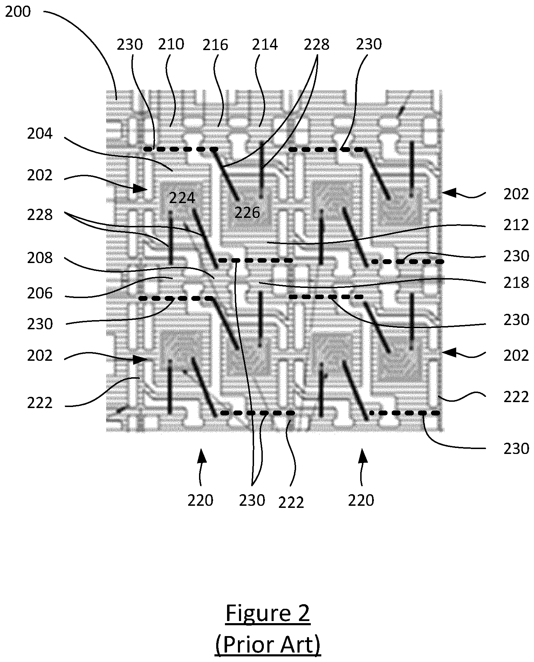

With reference to Figures 1 and 2, the method 100 begins at step 102 by providing a leadframe 200 having a plurality of sub-structures 202 arranged in a grid-like pattern. Four such sub-structures 202 are illustrated in Figure 2.

Each sub-structure 202 comprises a first die connection portion 204 associated with a first terminal-forming portion 206, second terminal-forming portion 208, and third terminal-forming portion 210. The third terminal-forming portion 210 is directly connected to the first die connection portion 204, whilst the first and second terminal-forming portions 206, 208 are indirectly connected to the first die connection portion 204 via a tie bar 222. The third terminal-forming portion 210 is positioned on a first side of the sub-structure 202, whilst the first and second terminal-forming portions 206, 208 are positioned on a second, opposite, side of the sub-structure 202.

Each sub-structure 202 further comprises a second die connection portion 212 associated with a fourth terminal-forming portion 214, fifth terminal-forming portion 216 and sixth terminal-forming portion 218. The sixth terminal-forming portion 218 is directly connected to the second die connection portion 212, whilst the fourth and fifth terminal-forming portions 214, 216 are indirectly connected to the second die connection portion 212 via a further tie bar 222. The third and fourth terminal-forming portions 214, 216 are positioned on the first side of the sub-structure 202, whilst the sixth terminal-forming portion 218 is positioned on the second side of the sub-structure 202.

The third terminal-forming portion 210, fifth terminal-forming portion 216 and fourth terminal-forming portion 414 are arranged in sequence from left to right on the first side of the sub-structure 202, and are substantially aligned with one another along a lateral axis. The first terminal-forming portion 206, second terminal-forming portion 208 and sixth terminal-forming portion 218 are arranged in sequence from left to right on the second side of the sub-structure 202, and are substantially aligned with one another along a lateral axis.

The sub-structures 202 are arranged in a series of longitudinally arranged columns 220 separated by tie bars 222. Within each adjacent pair of sub-structures 202 in a given column, the first terminal-forming portion 206 of a first one of the substructures 202 is defined by the same portion of the leadframe 200 as the third terminal-forming portion 210 of the adjacent one of the sub-structures 202. Likewise, the second terminal-forming portion 208 of the first substructures 202 is defined by the same portion of the leadframe 200 as the fifth terminal-forming portion 216 of the adjacent sub-structures 202. Finally, the sixth terminal-forming portion 219 of the first substructures 202 is defined by the same portion of the leadframe 200 as the fourth terminal-forming portion 214 of the adjacent one of the sub-structures 202.

The tie bars 222 runs beside each column 202 and are electrically connected to each die-connection portion 204, 212 and terminal-forming portion 206-210, 214-218.

Next, in step 104, a first die 224 is arranged upon and bonded to each of the first die-connection portions 204, and a second die 226 is arranged upon and bonded to each of the second die-connection portions 212. Such bonding is carried out using an electrically conductive adhesive, for example solder or the like.

In step 106, die bond wires 228 are bonded between the upper sides of the first dies 224 and the first and second terminal-forming portions 206, 208, and between the upper sides of the second dies 226 and the fourth and fifth terminal-forming portions 214, 216. The die bond wires 228 are shown in thick solid lines in Figure 2. The purpose of the die bond wires 228 is to provide an electrical connection between communication and/or power input and/or output portions situated on the upper surface of the dies 224, 226 and the terminal-forming portions 206, 208, 214, 216.

In step 108, sacrificial electroplating wires 230 are bonded between the tie bars 222 and the second terminal-forming portions 208 and between the tie bars 222 and the fourth terminal-forming portions 216. The electroplating wires 230 are shown in thick dashed lines in Figure 2. As will be discussed below, the purpose of the electroplating wires 230 is to ensure that all of the terminal-forming portions 260-210, 214-218 are in electrical communication so as to permit electroplating to be performed at a later stage.

Subsequently, in step 110 the assembly is encapsulated within an electrically insulating material, such as plastic, so as to form an encapsulation layer.

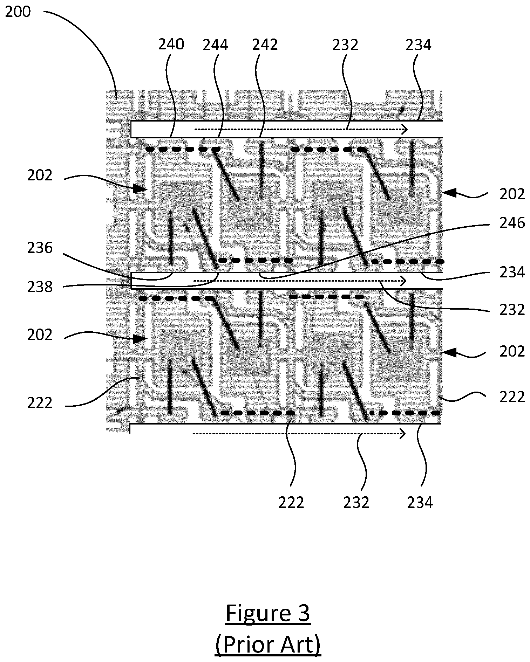

With reference to Figures 1 and 3, in step 112, a first series of cuts 232 are performed. The first cuts 232 extend in a lateral direction, and extend continuously across substantially all of the grid of sub-assemblies 202. In particular, each cut 232 in the first series of cuts removes material forming the tie bars 222 and first to sixth terminal-forming portions 206-210, 214-218 across the entire width of the grid. Each cut 232 results in the formation of a number of lateral channels 234 that extend continuously across the entire width of the grid of sub-structures 202. Removing the first to sixth terminal-forming portions 206-210, 214-218 exposes the ends of the leadframe 200 so as to define corresponding first to sixth side terminals 236-246. As a result of the cutting process, the side terminals 236-246 are formed flush with the sides of the channels 234. The first series of cuts 232 is performed using a so-called 'chopper', which is a form of rotary disc cutter akin to a circular saw.

The surfaces of the newly formed side terminals 236-246 require electroplating in order to protect them from undesirable corrosion / oxidation. Accordingly, in step 114 the leadframe 200 undergoes electroplating so as to protect the newly formed side terminals 236-246. During this process, an electric current is provided to the leadframe 200, which is carried to all of the side terminals via a combination of the remaining parts of the tie bars 222 and the electroplating wires 230.

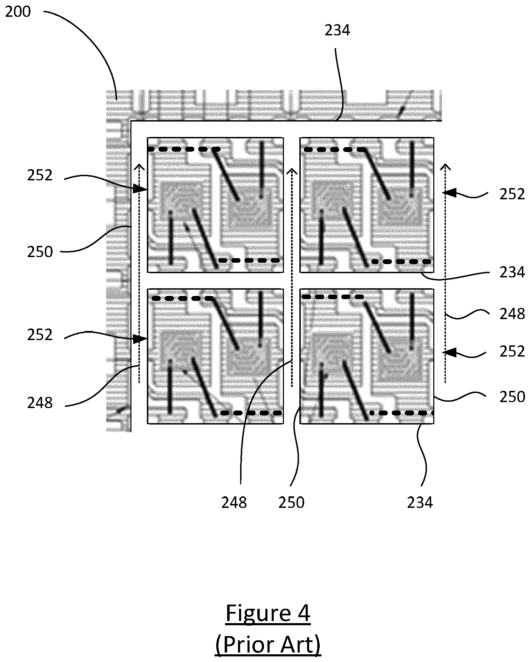

With reference to Figures 1 and 4, following completion of the electroplating, in step 116, a second series of cuts 248 is performed. The second cuts 248 are performed generally orthogonally to the first cuts 232. The second cuts 248 remove the tie bars 222 and create longitudinal channels 250. Following the formation of the channels 250, the individual sub-structures have 202 have been singulated into separate die packages 252. As in the case of the first cuts 232, the second cuts 248 are also performed using a 'chopper'.

With reference again to step 114 and Figure 3, without the presence of the electroplating wires 230, once the lateral channels 234 have been cut, it is not possible to provide all of the exposed side terminals 236-246 with an electric current. However, with reference to step 116 and Figure 4, once the longitudinal channels 250 have been cut, the electroplating wires 230 serve no further purpose.

It is therefore an object of the invention to mitigate or obviate the need to provide sacrificial electroplating wires 230 of the kind described above in relation to the prior art. It is a further object of the invention to mitigate or obviate one or more disadvantages of the prior art, whether described herein or elsewhere.

According to a first aspect of the invention, there is provided a method of manufacturing a semiconductor die package, the method comprising:
providing a leadframe having a sub-structure and at least one tie bar, the sub-structure comprising a terminal-forming portion in electrical communication with the at least one tie bar;
bonding a die to the sub-structure;
encapsulating the sub-structure and the die within an encapsulation layer;
performing a first cut through the terminal-forming portion and the encapsulation layer so as to form a side terminal, whilst leaving all tie bars substantially intact;
electroplating the side terminal; and
performing a second cut through the tie bar and the encapsulation layer to singulate a semiconductor die package from the leadframe.

Because the tie bar remains substantially intact whilst the first cut is performed, electrical communication between the tie bar and the terminal-forming portion is maintained as the side terminal is formed. Accordingly, this ensures that the newly formed side terminal is in electrical communication with the tie bar following the completion of the first cut. As a result, the tie bar may be used to carry an electric current to and/or from the newly formed side terminal for the purpose of electroplating. In particular, because such electrical communication is provided by the tie bar, it is not necessary to provide electrical communication via any additional sacrificial bonding wires. This reduces the number of wire connections, thereby considerably simplifying the manufacturing process and reducing material wastage.

The term "sub-structure" is intended to refer only to a part of the leadframe that is to be singulated into the eventual semiconductor die package.

The term "substantially intact" does not preclude some degree of cutting of the tie bar, provided that once the first cut is complete the tie bar remains electrically connected to the newly formed side terminal.

The term "terminal-forming portion" encompasses a part of the leadframe which, when cut, will form a side terminal of the sub-structure.

The term "side terminal" encompasses an exposed portion of the leadframe suitable for connection to an electrical circuit within which the die package will be integrated.

It will be appreciated that the leadframe may have a single tie bar or a plurality of tie bars. However, in the case of a leadframe comprising a plurality of tie bars, all of the tie bars must remain substantially intact following the first cut.

The sub structure may comprise a plurality of terminal-forming portions, and the step of performing the first cut comprises cutting through the plurality of terminal-forming portions and the encapsulation layer so as to form a plurality of side terminals, whilst leaving the tie bar substantially intact. The terminal-forming portions may be substantially aligned along a lateral axis. The first cut need not be a single cut, and may comprise a series of cuts to form a side terminal at each respective terminal-forming portion.

The first cut may be performed using laser cutting. Because laser cutting is highly precise, it is well suited to the performance of the first cut (or first series of cuts). However, substantially any form of cutting may be performed in the alternative.

Performing the second cut may comprise entirely removing the tie bar. That is to say, following the second cut (or second series of cuts), in such an embodiment, substantially all of the tie bar will have been removed.

The leadframe may define a plurality of said sub-structures electrically connected via the tie bar. Each sub-structure may further be electrically connected to an adjacent sub-structure via their respective terminal-forming portions. Furthermore, the step of bonding a die to the sub-structure may comprise bonding a die to each of the plurality of sub-structures. Additionally, the step of encapsulating the sub-structure and the die within the encapsulation layer may comprise encapsulating each of the plurality of subs structures and their associated dies within the encapsulation layer. The step of performing the first cut may comprise performing a first series of cuts through the terminal-forming portions and the encapsulation layer so as to form side terminals in each sub-structure, whilst leaving the tie bar substantially intact.

The plurality of sub-structures may be arranged in a column. The leadframe may comprise a plurality of said columns, and adjacent columns may be interposed by tie bars electrically connected to each sub-structure in said adjacent columns. Furthermore, the step of performing a second cut may comprise performing a second series of cuts through the tie bars and the encapsulation layer to singulate a plurality of semiconductor die packages from the leadframe.

The first series of cuts may extend in a generally lateral direction. The lateral direction corresponds to the row-wise direction of the sub-structures. The second series of cuts may extend in a generally longitudinal direction. The longitudinal direction corresponds to the column-wise direction of the sub-structures.

The method may further comprise the step of bonding a wire between an upper surface of the die and the terminal-forming portion.

According to a second aspect of the invention, there is provided a manufacturing intermediate for a semiconductor die package, the manufacturing intermediate comprising:
a leadframe defining a plurality of sub-structures arranged in a grid extending in a lateral direction and a longitudinal direction, the leadframe comprising a plurality of longitudinally extending tie bars positioned between laterally adjacent pairs of sub-structures;
a plurality of dies, each die bonded to a separate one of the sub-structures;
an encapsulation layer encapsulating the leadframe and the dies; and
a plurality of laterally extending channels penetrating the encapsulation layer and the leadframe, the channels positioned between each pair of longitudinally adjacent sub-structures and comprising side terminals in electrical communication with the tie bars;
wherein the tie bars extend longitudinally between laterally adjacent pairs of channels.

The term "manufacturing intermediate for a semiconductor die package" encompasses an assembly of sub-components configured to form one or more semiconductor die packages. That is to say, the manufacturing intermediate is a product of the result of an incomplete process in the manufacture of a semiconductor die package.

Because the manufacturing intermediate comprises tie bars that extend longitudinally between laterally adjacent pairs of channels, and because the tie bars are in electrical communication with the side terminals, this enables the tie bars to provide electrical current to all of the side terminals in the manufacturing intermediate. Accordingly, it is possible to perform electroplating upon all of the side terminals of the manufacturing intermediate.

The channels may be aligned in laterally extending rows, each row comprising a series of channels.

The tie bars may extend generally longitudinally across the entire longitudinal dimension of the grid of sub-structures.

A detailed description of the invention is provided below with reference to the accompanying drawings, in which:
Figure 1 is a flow chart of a prior art method of manufacturing a semiconductor die package;
Figure 2 is a schematic plan view of a prior-art leadframe according to the method of Figure 1 following the completion of the step of bonding sacrificial electroplating wires;
Figure 3 is a schematic plan view of the prior-art leadframe according to the method of Figure 1 following the completion of the step of performing a first series of cuts;
Figure 4 is a schematic plan view of the prior-art leadframe according to the method of Figure 1 following the completion of the step of performing a second series of cuts;
Figure 5 is a flow chart of a method of manufacturing a semiconductor die package according to the present invention;
Figure 6 is a schematic plan view of a leadframe according to the method of Figure 5 following the completion of the step of bonding die wires;
Figure 7 is a schematic plan view of the leadframe according to the method of Figure 5 following the completion of the step of performing a first series of cuts; and
Figure 8 is a schematic plan view of the leadframe according to the method of Figure 5 following the completion of the step of performing a second series of cuts.

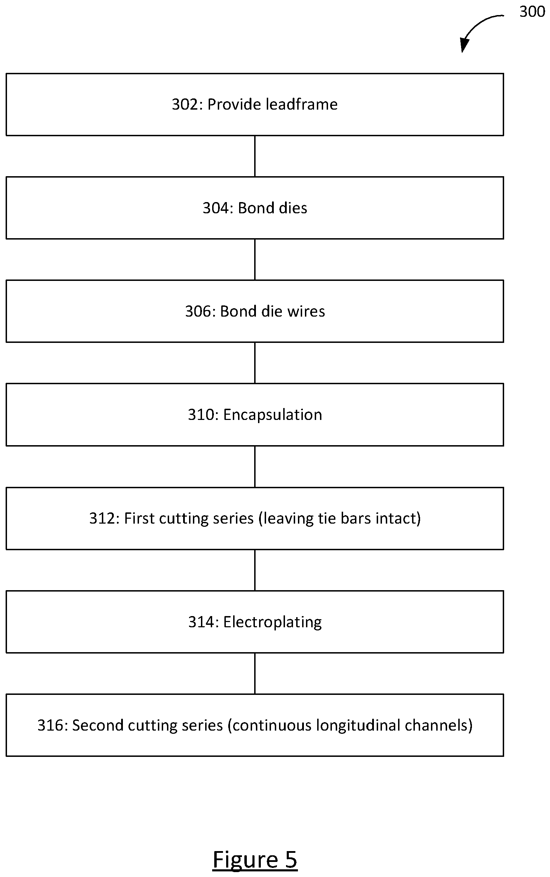

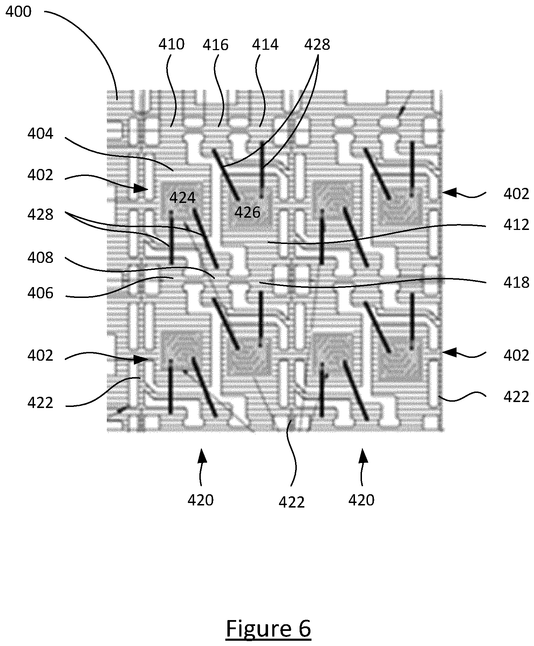

Figures 5 to 8 illustrate a method 300 of manufacturing a semiconductor die package according to the present invention and a corresponding leadframe assembly 400. The method 300 is substantially similar to the prior art method 100 in relation to Figure 1 and therefore corresponding reference numerals have been used, beginning from 300. Likewise the leadframe assembly 400 described below in relation to Figures 6 to 8 is substantially similar to the prior art leadframe assembly 200 described in relation to Figures 2 to 4 and therefore corresponding reference numerals have been used, beginning from 400.

Steps 302 to 306 of the method 300 of the present invention are substantially identical to steps 102 to 106 of the prior art method 100 described above. However, the prior art step 108 of bonding the sacrificial electroplating wires 230 is omitted form the method 300 of the present invention. As shown in Figure 6, no sacrificial electroplating wires are provided upon the leadframe 400 of the present invention.

Step 310 of the method 300 of the present invention is substantially identical to step 110 of the prior art method 100 described above.

Step 312 of the method 300 of the present invention, in which a first series of cuts is performed, differs from the corresponding step 112 of the prior art method 100 described above. In particular, whilst the prior art step 112 includes cutting across the entire lateral width of the grid of sub-structures 202, in the step 312 of the present invention only the terminal-forming portions 406-410, 414-418 and their associated portions of the encapsulation layer are cut. In particular, each cut 432 extends through the first terminal-forming portion 406 and/or third terminal-forming portion 410, second terminal-forming portion 408 and/or fifth terminal-forming portion 416, and sixth terminal-forming portion 418 and/or fourth terminal-forming portion 414. That is to say, the cuts 432 extend through each lateral trio of terminal-formation portions. However, the tie bars 422 and their associated portions of the encapsulation layer are not cut during this process, and remain substantially intact.

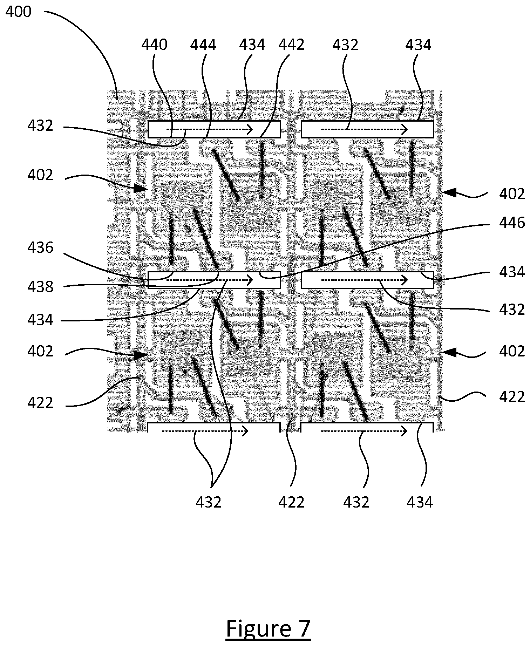

With reference to Figure 7, this results in the formation of a series of laterally extending channels 434 positioned between each longitudinally adjacent pair of sub-structures 402. The tie bars 422 extend in a longitudinal direction in between each laterally adjacent pair of channels 434, which permits electricity distribution to each row of the grid. Accordingly, as compared to the prior art, in the present invention the tie bars 422 remain in electrical communication with all of the side terminals 436-446. Put another way, by discretising the continuous lateral cuts 232 of the prior art into a series of smaller cuts interposed by longitudinally extending tie bars 422, the present invention maintains all side terminals 436-446 in the leadframe 400 in electrical communication with one another. Therefore, the electrical current necessary for electroplating can be provided to all of the side terminals 436-446 via the tie bars 422, without the need to include sacrificial electroplating wires 230 of the kind previously described. By avoiding the need to provide sacrificial electroplating wires 230, the present invention reduces the complexity of the overall manufacturing process, as well as reducing material wastage.

Moreover, because the tie bars 422 remain intact so as to provide electrical communication to all of the side terminals 436-446, the method of the present invention can be used to manufacture die packages comprising substantially any number of side terminals without the need to provide sacrificial electroplating wires 230.

It will be appreciated that although the tie bars 422 must remain substantially intact during the performance of the first series of cuts 432, some degree of removal of the tie bars 422 may take place, provided that the tie bars 422 remain capable of transmitting electrical current between adjacent rows of sub-structures 402 in the grid. Accordingly, as a minimum, the tie bars 422 cannot be completely severed, and preferably as much as possible (if not all) of the tie bars 422 should remain following the performance of the first series of cuts 432.

Preferably, the step 312 of performing the first series of cuts according to the present invention is carried out using a laser cutter. It has been found that laser cutters are particularly well-suited to such an application, since they provide very precise control over the cutting position. The size of the channels 434 is generally very small, and therefore the precise control afforded by the use of a laser cutter improves ease of manufacture. However, it will nevertheless be appreciated that, in principle, it is possible to form the series of channels 434 using any suitable machining method, including a so-called 'chopper'.

Following the completion of performing the first series of cuts in step 312, in step 314 the side terminals 436-446 are electroplated.

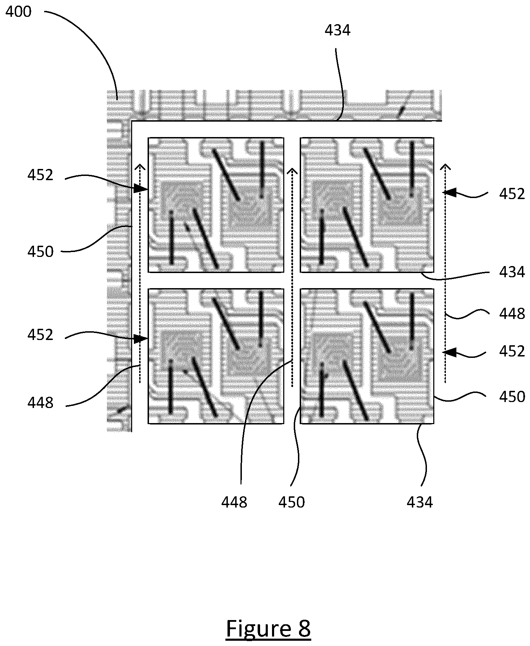

Finally, with reference to Figures 5 and 8, in step 314 a second series of cuts 448 is performed in a substantially identical manner to step 114 of the prior art method 100. In particular, in the second cutting step 314, substantially all of the tie bars 422 are removed, thus resulting in the singulation of individual die packages 452. This step is preferably carried out using a 'chopper', but may alternatively be carried out by laser cutting.

Whilst the leadframe 400 comprises a rectangularly arranged grid of sub-structures 402, it will be appreciated that in alternative embodiments the sub-structures 402 may not be arranged in a rectangular grid. For example, the sub-structures 402 may be tessellated in a triangular pattern, hexagonal pattern, or be otherwise positioned in any arbitrary layout. Moreover, adjacent rows of sub-structures 402 may be staggered in relation to one another. However, in order to perform the method of the present invention, the tie bars 422 must remain substantially intact following the first series of cuts 432 so as to maintain all of the side terminals 436-446 in electrical communication with one another.

Furthermore, the tie bars 422 need not extend exactly orthogonally to rows of sub-structure 402 but may be inclined at any arbitrary angle. In such arrangements, the second cuts 448 may be inclined at the same angle as the tie bars 422 so as to remove substantially all of the tie bars 422.

It will be appreciated that the method 300 of the present invention is equally as applicable to the manufacture of a single die package 452 from a leadframe 400 comprising a single sub-structure 402 as it is to the manufacture of a plurality of die packages 452 from a leadframe comprising plurality of sub-structures 402.

It will be appreciated that although the cuts 432 extend through each lateral trio of terminal-formation portions to form a continuous channel 434, in alternative embodiments the individual terminal-forming potions 406-410, 414-418 themselves may be cut separately, so as to form a separate channel 434 for each terminal-forming portion 406-410, 414-418. In such embodiments, it is necessary to subsequently perform an additional series of cuts to fully singulate the individual die packages 452.

## Claims

1. A method of manufacturing a semiconductor die package, the method comprising:
providing a leadframe having a sub-structure and at least one tie bar, the sub-structure comprising a terminal-forming portion in electrical communication with the at least one tie bar;
bonding a die to the sub-structure;
encapsulating the sub-structure and the die within an encapsulation layer;
performing a first cut through the terminal-forming portion and the encapsulation layer so as to form a side terminal, whilst leaving all tie bars substantially intact;
electroplating the side terminal; and
performing a second cut through the tie bar and the encapsulation layer to singulate a semiconductor die package from the leadframe.

2. A method according to claim 1, wherein the sub structure comprises a plurality of terminal-forming portions, and the step of performing the first cut comprises cutting through the plurality of terminal-forming portions and the encapsulation layer so as to form a plurality of side terminals, whilst leaving the tie bar substantially intact.

3. A method according to any preceding claim, wherein the first cut is performed using laser cutting.

4. A method according to any preceding claim, wherein performing the second cut comprises entirely removing the tie bar.

5. A method according to any preceding claim, wherein the leadframe defines a plurality of said sub-structures electrically connected via the tie bar, each sub-structure further being electrically connected to an adjacent sub-structure via their respective terminal-forming portions;
wherein the step of bonding a die to the sub-structure comprises bonding a die to each of the plurality of sub-structures;
wherein the step of encapsulating the sub-structure and the die within the encapsulation layer comprises encapsulating each of the plurality of subs structures and their associated dies within the encapsulation layer; and
wherein the step of performing the first cut comprises performing a first series of cuts through the terminal-forming portions and the encapsulation layer so as to form side terminals in each sub-structure, whilst leaving the tie bar substantially intact.

6. A method according to claim 5, wherein the plurality of sub-structures are arranged in a column, the leadframe comprises a plurality of said columns, and adjacent columns are interposed by tie bars electrically connected to each sub-structure in said adjacent columns; and
wherein the step of performing a second cut comprises performing a second series of cuts through the tie bars and the encapsulation layer to singulate a plurality of semiconductor die packages from the leadframe.

7. A method according to claim 5 or 6, wherein the first series of cuts extend in a generally lateral direction.

8. A method according to claim 6 or 7, wherein the second series of cuts extend in a generally longitudinal direction.

9. A method according to any preceding claim, further comprising the step of bonding a wire between an upper surface of the die and the terminal-forming portion.

10. A manufacturing intermediate for a semiconductor die package, the manufacturing intermediate comprising:
a leadframe defining a plurality of sub-structures arranged in a grid extending in a lateral direction and a longitudinal direction, the leadframe comprising a plurality of longitudinally extending tie bars positioned between laterally adjacent pairs of sub-structures;
a plurality of dies, each die bonded to a separate one of the sub-structures;
an encapsulation layer encapsulating the leadframe and the dies; and
a plurality of laterally extending channels penetrating the encapsulation layer and the leadframe, the channels positioned between each pair of longitudinally adjacent sub-structures and comprising side terminals in electrical communication with the tie bars;
wherein the tie bars extend longitudinally between laterally adjacent pairs of channels.

11. A manufacturing intermediate according to claim 10, wherein the channels are aligned in laterally extending rows, each row comprising a series of channels.

12. A manufacturing intermediate according to claim 10 or 11, wherein the tie bars extend generally longitudinally across the entire longitudinal dimension of the grid of sub-structures.
